# FASCICULE DE BREVET EUROPEEN

(11) **EP 4 016 588 B1**
(45) Date de publication et mention de la délivrance du brevet: **29.05.2024**
(21) Numéro de dépôt: 21212573.6
(22) Date de dépôt: 06.12.2021
(51) Int. Cl.: H01L 21/322, H01L 21/265, H01L 21/268, H01L 21/74, H01L 21/762, H03H 3/08

(54) **STRUCTURE AMÉLIORÉE DE SUBSTRAT RF ET PROCÉDÉ DE RÉALISATION**
VERBESSERTE STRUKTUR EINES RF-SUBSTRATS UND ENTSPRECHENDES HERSTELLUNGSVERFAHREN
IMPROVED STRUCTURE FOR RF SUBSTRATE AND MANUFACTURING METHOD

(30) Priorité: 16.12.2020 FR 2013364
(43) Date de publication de la demande: 22.06.2022
(73) Titulaire: Commissariat à l'énergie atomique et aux énergies alternatives, 75015 Paris (FR)
(72) Inventeur: ACOSTA ALBA, Pablo, 38054 GRENOBLE CEDEX 09 (FR); AUGENDRE, Emmanuel, 38054 GRENOBLE CEDEX 09 (FR); LORNE, Thomas, 38054 GRENOBLE CEDEX 09 (FR); REBOH, Shay, 38054 GRENOBLE Cedex 09 (FR); ROLLAND, Emmanuel, 38054 GRENOBLE CEDEX 09 (FR)
(74) Mandataire: Brevalex

(56) Documents cités:
- EP-A1- 3 840 033
- WO-A1-2016/087728
- WO-A2-2011/066035
- FR-A1- 2 794 897
- US-A1- 2018 337 043

## Description

Le domaine de l'invention est celui des substrats de type semi-conducteur sur isolant, notamment pour des applications radiofréquences (RF).

L'invention concerne plus particulièrement une structure améliorée de substrat de type semi-conducteur ou piézoélectrique sur isolant à couche de piégeage de charges électriques (« trap rich ») ainsi que son procédé de fabrication.

Pour les applications RF, et en particulier celles fonctionnant à une fréquence élevée et typiquement supérieure à 700 MHz, les substrats doivent servir de support aux circuits sans en perturber leur fonctionnement. On cherche en particulier à éliminer les pertes de propagation, la diaphonie ou les harmoniques parasites.

Divers types de substrats sont aujourd'hui utilisés pour les applications RF notamment des substrats en verre, en quartz, en silicium hautement résistif, en céramique. Ces substrats ont en commun de se comporter comme une épaisseur isolante de façon à éviter les pertes d'origine ohmique et les couplages capacitifs parasites.

Les substrats de type semi-conducteur sur isolant adaptés pour les applications RF, en particulier ceux de type RF-SOI (SOI pour « Silicon On Insulator » ou « Silicium sur isolant ») ont quant à eux pour avantage de permettre une co-intégration de circuits RF avec d'autres circuits tels que des interrupteurs, des amplificateurs réalisés dans une technologie plus conventionnelle.

Un substrat de type semi-conducteur sur isolant est communément formé d'une couche semi-conductrice de support recouverte par, et en contact avec, une couche isolante, elle-même recouverte par, et en contact avec, une couche superficielle semi-conductrice généralement destinée à servir de couche active, c'est-à-dire dans laquelle des composants actifs, tels que des transistors, ou des composants passifs, en particulier de circuits RF, sont destinés à être formés.

Pour les applications RF, des adaptations connues de ces substrats consistent à :
- prévoir une couche de support en matériau semi-conducteur résistif faiblement dopée et,
- former sous et contre la couche isolante communément appelée « BOX » une couche de piégeage communément appelée « trap rich » c'est-à-dire formée d'un matériau semi-conducteur riche en défauts cristallins et/ou en joints de grains et qui permet de piéger des charges. Sans cette couche de piégeage, des charges fixes (positives) dans le BOX induiraient la présence de charges mobiles (électrons) dans la couche de support au voisinage du BOX, annulant localement le bénéfice du faible dopage de la couche de support.

La couche de piégeage est d'ordinaire formée d'une couche de silicium polycristallin. La couche de silicium polycristallin fonctionne d'autant mieux qu'elle possède une forte densité de joints de grains qui constituent autant de sites de piégeage.

L'efficacité de la couche de piégeage peut être toutefois réduite lorsque, durant la fabrication du substrat puis du dispositif final sur ce substrat, elle subit certaines étapes de traitement thermique. À des températures élevées par exemple supérieures à 1000°C, on peut notamment avoir, dans la couche de piégeage, une taille des grains qui croit, ce qui peut réduire son efficacité.

Pour parer les effets néfastes de traitements thermiques sur la couche de piégeage on peut prévoir d'intégrer une couche intercalaire entre la couche de support en matériau semi-conducteur hautement résistif et la couche de piégeage en silicium polycristallin. Cela permet de retarder une transmission de la structure cristalline de la couche de support à la couche de piégeage en matériau polycristallin et d'empêcher ainsi de modifier la structure de cette dernière.

Dans le document WO2012/127006, une telle couche intercalaire est prévue en oxyde de silicium, tandis que dans le document WO2017/144821 A1 on intègre une couche intercalaire en carbone ou en SiC. Dans ces procédés, au moins une étape supplémentaire de polissage par CMP (« Chemical mechanical polishing » ou Planarisation mécano-chimique) est mise en oeuvre. Or, l'utilisation de ce type d'étape peut s'avérer couteuse. Le document WO2016/149113, prévoit quant à lui la réalisation d'une couche de piégeage dans du silicium dans lequel on forme des cavités que l'on remplit ensuite par du polysilicium ou bien du silicium amorphe voire de l'oxyde de silicium. Le remplissage est là encore typiquement suivi d'une étape de polissage par CMP. < insérer page 3a >

Il se pose le problème de trouver une structure améliorée de substrat à couche active sur isolant.

### EXPOSÉ DE L'INVENTION

Selon un aspect, la présente demande concerne un substrat comprenant une couche superficielle disposée sur, et en contact avec, une couche isolante, ladite couche isolante étant disposée sur, et en contact avec, un socle,
ledit socle comprenant :
   - une couche de support en matériau semi-conducteur donné,
   - une couche de piégeage de charges, ladite couche de piégeage comprenant une couche en matériau semi-conduteur polycristallin située entre ladite couche isolante et ladite couche de support,
ledit socle comprenant en outre, entre ladite couche de support et ladite couche isolante:
   - une couche poreuse dotée d'une face inférieure en contact avec ladite couche de support, ladite couche poreuse étant formée d'un squelette solide et d'une distribution de pores qui sont vides et/ou remplis de gaz.

Les pores de la couche poreuse sont des pores fermés.

Une telle couche poreuse peut permettre d'empêcher la propagation d'un front de recristallisation de la couche de support vers la couche isolante tout en agissant comme une couche de piégeage de charges.

Le matériau semi-conducteur donné de la couche de support peut être en particulier un matériau de résistivité supérieure à 500 Ω.cm.

Le document FR2794897A1 présente une structure particulière de substrat comprenant une couche une couche poreuse à pores ouverts et une couche retenant les gaz comprenant du silicium polycristallin.

La couche superficielle peut être une couche dans laquelle ou au-dessus de laquelle au moins un composant, en particulier un composant de circuit RF, est formé ou apte à être formé.

Le composant RF peut être en particulier une inductance ou une antenne.

Selon un agencement particulier, le composant RF peut être formé au-dessus d'une région où la couche semi-conductrice superficielle n'est pas présente et peut avoir été remplacée, par exemple par une couche d'oxyde de silicium (typiquement du SiO₂).

Selon un mode de réalisation, la couche de matériau semi-conducteur polycristallin comprend une face supérieure en contact avec la couche isolante et une face inférieure opposée à la face supérieure, la face inférieure étant en contact avec la couche poreuse.

Avantageusement, une portion supérieure du squelette solide de la couche poreuse est en contact avec la face inférieure et étant en matériau semi-conduteur polycristallin. Dans ce cas, une portion inférieure du squelette solide de la couche poreuse peut être en matériau semi-conduteur monocristallin.

Avantageusement, la couche de piégeage de charges et la couche poreuse sont des couches distinctes, ledit squelette solide étant au moins partiellement monocristallin.

Selon un mode de réalisation particulier, le squelette solide de la couche poreuse est intégralement en matériau semi-conducteur monocristallin, la couche poreuse et la couche en matériau semi-conduteur polycristallin étant superposées.

Selon un mode de réalisation particulier, une couche de matériau semi-conducteur amorphe peut être agencée entre la couche de piégeage de charges et la couche poreuse.

Selon un mode de réalisation avantageux, la couche de matériau semi-conduteur polycristallin et la couche poreuse sont localisées et situées en regard d'une région donnée de ladite couche superficielle tandis qu'une autre région de ladite couche superficielle juxtaposée à ladite région donnée n'est pas située en regard de ladite couche de matériau semi-conduteur polycristallin ou de ladite couche poreuse.

Avantageusement, ledit matériau semi-conduteur polycristallin est du silicium polycristallin.

La présente demande concerne également une structure comprenant un tel substrat et/ou formée à partir d'un tel substrat.

Selon un aspect particulier, la présente demande concerne un dispositif microélectronique muni d'une structure dotée d'un substrat tel que défini plus haut avec une couche superficielle semi-conductrice, le dispositif microélectronique comprenant :
- au moins un transistor, le transistor ayant une région de canal agencée dans ladite couche semi-conductrice superficielle, et/ou
- au moins un composant RF, en particulier de type inductance ou antenne.

Le composant RF peut être formé au-dessus de la couche semi-conductrice superficielle ou au-dessus d'une région juxtaposée à la couche semi-conductrice superficielle et en particulier une région formée d'une couche d'oxyde de silicium typiquement du SiO₂.

Selon un aspect particulier, la présente demande concerne un substrat tel que défini plus haut avec une couche superficielle en matériau piézoélectrique.

Selon un autre aspect, la présente demande concerne un procédé de fabrication d'une structure telle que définie plus haut.

La couche poreuse est typiquement réalisée par porosification d'une couche en matériau semi-conducteur donné du socle.

Selon une possibilité de mise en oeuvre, la porosification peut être réalisée par implantation d'hydrogène ou de gaz rare, l'implantation étant suivie d'un recuit thermique et/ou d'un traitement laser.

Selon une possibilité de mise en oeuvre, la porosification peut être est effectuée de sorte à former en surface dudit socle une région de surface poreuse.

Ainsi, lorsque la porosification comprend au moins une implantation, cette implantation peut être effectuée de sorte à former en surface dudit socle une région de surface poreuse.

Selon une possibilité de mise en oeuvre, la réalisation de la couche en matériau semi-conduteur polycristallin peut comprendre un dépôt d'une couche de matériau semi-conducteur amorphe sur la couche poreuse, et en particulier directement en contact sur cette couche poreuse.

La réalisation de la couche en matériau semi-conduteur polycristallin peut également comprendre une implantation d'amorphisation d'une région dudit socle. On forme ainsi une région amorphe.

Selon une autre possibilité de mise en oeuvre du procédé, la couche poreuse est formée par implantation de sorte à conserver sur la couche poreuse une région de surface non poreuse, l'implantation d'amorphisation étant alors réalisée de sorte à former la région amorphe dans au moins cette région de surface ou dans au moins cette région de surface ainsi que dans une partie supérieure de la couche poreuse.

Selon un mode de réalisation, le procédé peut comprendre en outre une étape de recristallisation, par recuit laser et/ou par recuit thermique de température et de durée prévues de sorte à transformer ladite couche en matériau semi-conducteur amorphe ou ladite région amorphe en ladite couche de matériau polycristallin.

Avantageusement, la couche poreuse et la couche de matériau polycristallin peuvent être réalisés dans un substrat massif formant le socle, le procédé comprenant en outre une étape de report d'un substrat donneur sur le substrat massif, le substrat donneur comprenant une couche isolante et une couche en matériau piézoélectique ou semi-conductrice dans laquelle la couche superficielle est apte à être formée.

Une étape de retrait d'une portion du substrat donneur et en particulier de la couche donnée peut être ensuite avantageusement réalisée, par exemple par un procédé de type smartcut^{™} ou dans lequel on créé une zone de fragilisation dans le substrat poignée, puis de séparation d'une épaisseur du substrat poignée au niveau de cette zone de fragilisation.

En variante, la couche poreuse est réalisée dans un substrat massif formant ledit socle, et la couche de matériau polycristallin est réalisée après report, en particulier par collage, dudit substrat massif sur un substrat donneur comprenant une couche isolante.

En variante, la couche poreuse et la couche de matériau polycristallin sont réalisées après report, en particulier par collage dudit substrat massif sur un substrat donneur comprenant une couche isolante.

Selon une autre variante, la couche poreuse et la couche de matériau polycristallin sont réalisées dans un substrat de type semi-conducteur sur isolant ou dans une structure de substrat de type semi-conducteur sur isolant en cours de réalisation.

Avantageusement, le procédé peut alors comprendre en outre la formation d'une couche de fermeture de porosité sur ladite face donnée.

La réalisation de la couche de fermeture de porosité peut comprendre au moins une étape de :
- implantation d'amorphisation d'une portion supérieure de ladite région supérieure poreuse et/ou,
- dépôt d'une couche de matériau semi-conducteur amorphe sur ladite région supérieure poreuse.

Avantageusement, la couche de fermeture de porosité est une région en silicium amorphe et dans lequel le procédé comprend en outre au moins un traitement thermique de sorte à transformer ladite région de silicium amorphe en région à base de polysilicium.

Après porosification, le procédé peut également comprendre au moins un recuit thermique d'évacuation d'espèces gazeuse des pores.

Après porosification, le procédé peut également comprendre au moins un recuit thermique, en particulier sous atmosphère oxydante, de renforcement dudit squelette solide.

### BRÈVE DESCRIPTION DES DESSINS

La présente invention sera mieux comprise sur la base de la description qui va suivre et des dessins en annexe sur lesquels :
La figure 1 sert à illustrer un substrat suivant un mode de réalisation de la présente invention adapté pour des applications RF et muni d'une couche de matériau semi-conducteur poreux ;
Les figures 2A, 2B servent à illustrer un dispositif microélectronique RF réalisé sur un substrat tel que mis en oeuvre suivant un mode de réalisation de la présente invention ;
Les figures 3A, 3B, 3C, 3D, 3E, 3F servent à illustrer un exemple de procédé de fabrication d'un socle pour substrat de type semi-conducteur sur isolant, ce socle comportant une couche de matériau semi-conducteur polycristallin et une couche poreuse ;
Les figures 4A, 4B 4C servent à illustrer un exemple de procédé de fabrication d'un substrat donneur destiné à être assemblé à un socle pour former un substrat de type semi-conducteur sur isolant ;
Les figures 5A, 5B servent à illustrer un exemple de procédé d'assemblage dans lequel une couche isolante et une couche superficielle semi-conductrice sont assemblées à un socle afin de former un substrat de type semi-conducteur sur isolant ;
Les figures 6A, 6B 6C, 6D, 6E servent à illustrer un autre exemple de procédé de fabrication d'un socle muni d'une couche de piégeage de charges pour former un substrat RF de type semi-conducteur sur isolant amélioré ;
La figure 7 sert à illustrer un autre exemple de substrat de type semi-conducteur sur isolant pour applications RF et muni d'une couche de matériau semi-conducteur poreux servant de couche de piégeage de charges ;
La figure 8 sert à un illustrer un substrat de type POI mis en oeuvre suivant un mode de réalisation de la présente invention ;
Les figures 9A, 9B, 9C, 9D, 9E, 9F servent à illustrer un autre exemple de procédé de fabrication d'un substrat de type semi-conducteur sur isolant muni d'une couche de piégeage de charges directement dans ce substrat ;
Les figures 10A, 10B servent à illustrer une variante de procédé de fabrication d'un substrat de type semi-conducteur sur isolant ;
La figure 11 sert à illustrer une structure particulière à partir de laquelle une couche poreuse et une couche de matériau semi-conducteur polycristallin peuvent être formées pour réaliser la couche de piégeages de charges ;
La figure 12 servent à illustrer un autre exemple de procédé de fabrication d'un socle muni d'une région de piégeage localisée et qui ne s'étend pas sur toute la largeur du substrat ;
Les figures 13A, 13B, 13C servent à illustrer un autre exemple de procédé de fabrication d'une région de piégeage localisée à partir d'un substrat de type semi-conducteur sur isolant ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation d'une structure tels que « avant », « supérieure », « arrière », « inférieure », s'appliquent en considérant que la structure est orientée de la façon illustrée sur les figures.

### EXPOSÉ DÉTAILLÉ DE MODES DE RÉALISATION PARTICULIERS

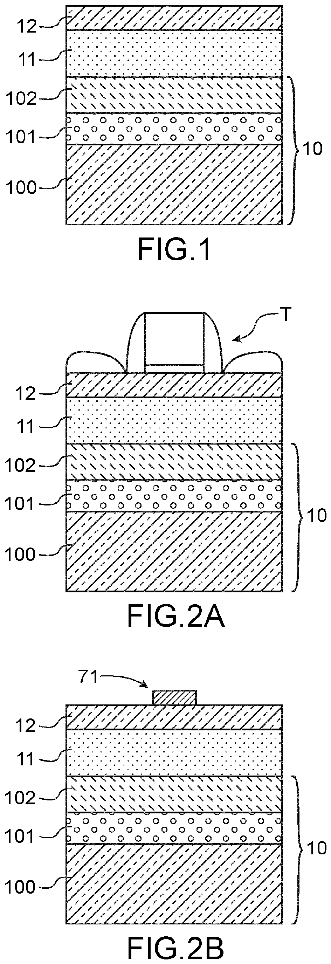

Un substrat de type semi-conducteur sur isolant tel que mis en oeuvre suivant un mode de réalisation de la présente invention est illustré sur la figure 1.

Ce substrat comprend une couche semi-conductrice superficielle 12 dans laquelle au moins un composant ou une portion de composant, en particulier d'un circuit RF, est destiné(e) à être au moins partiellement formé(e). La couche semi-conductrice superficielle 12 peut accueillir notamment la région de canal de transistors. La couche semi-conductrice superficielle 12 peut être également une couche sur laquelle on prévoit de réaliser un ou plusieurs composants RF (radiofréquences), c'est-à-dire d'émission et/ou réception de signaux RF par exemple tels qu'une antenne ou une inductance.

La couche semi-conductrice superficielle 12 a une épaisseur qui peut être comprise entre 10 nm et 1 µm. Cette couche superficielle 12 peut être par exemple en silicium dans le cas où le substrat est de type SOI et repose sur une couche isolante 11. La couche isolante 11 est typiquement en oxyde de silicium 11 et a une épaisseur qui peut être comprise entre 10 nm et 1 µm. La couche isolante 11 est en contact avec la couche superficielle 12 et isole cette dernière d'un socle 10 formé ici d'une superposition de couches 100, 101, 102.

Le socle 10 comprend une couche 100 dite « de support » prévue à base d'un matériau semi-conducteur résistif, autrement dit de résistivité élevée, c'est-à-dire supérieure à 500 Ω.cm et de préférence supérieure à 1 kΩ.cm.

Entre cette couche de support 100 et la couche isolante 11, au moins une couche de piégeage de charges est prévue, de préférence deux couches de piégeage de charge sont prévues, pour permettre d'adapter le substrat à des applications RF en limitant les pertes de propagation et les phénomènes de diaphonie. La première couche de piégeage de charges, est une couche comportant des défauts cristallins et/ou des joints de grains. La couche de piégeage de charges comprend ou est formée d'une couche 102 en matériau semiconducteur polycristallin, typiquement du silicium polycristallin. La couche 102 de matériau semiconducteur polycristallin est située sous la couche isolante 11 et se trouve de préférence directement en contact avec cette dernière. La couche 102 de matériau semiconducteur polycristallin a une épaisseur qui est typiquement inférieure à celle de la couche de support 100 et qui peut être comprise par exemple entre 5 nm et 1 µm, avantageusement entre 5 nm et 500 nm, de préférence entre 5 nm et 50 nm.

Pour permettre notamment d'empêcher une recristallisation de cette couche à partir de la couche 100 de support lors d'éventuels recuits thermiques que peut être amené à subir le substrat, ce dernier a pour particularité de comporter une couche poreuse 101. Cette couche poreuse 101 sépare ici la couche de matériau semiconducteur polycristallin 102 et la couche 100 de support. La couche poreuse 101 participe également à limiter les phénomènes de conduction parasite sous l'isolant et forme alors la deuxième couche de piégeage de charges.

La couche poreuse 101 est dans cet exemple dotée d'une portion supérieure en contact avec une face inférieure de la couche 102 de matériau semiconducteur polycristallin. La couche 102 de matériau semiconducteur polycristallin 102 est ainsi intercalée entre la couche poreuse 101 et la couche d'oxyde 11. La couche poreuse 101 peut être prévue avec une épaisseur comprise par exemple entre 30 nm et 2 µm, avantageusement entre 30 nm et 1 µm.

La couche poreuse 101 comporte une porosité formée d'une distribution de pores, en particulier des pores fermés, typiquement vides et/ou remplis de gaz, typiquement un gaz rare ou de l'hydrogène. Une telle couche 101 par exemple en silicium poreux, peut être en particulier obtenue par porosification de la couche 100 de support. La couche poreuse 101 peut être ainsi formée d'un squelette solide à base du même matériau que la couche de support, tel que du silicium monocristallin, et qui laisse apparaître des espaces ou pores qui ne sont pas remplis de matériau à l'état solide. Les pores peuvent avoir un diamètre compris par exemple entre 2 nm et 250 nm, avantageusement entre 5 nm et 100 nm.

Le type de porosité, ici à pores majoritairement fermés, dépend de son procédé d'obtention. Par exemple, un procédé dans lequel la porosification comprend une implantation peut favoriser l'obtention de pores fermés tandis qu'un traitement chimique ou électrochimique conduirait à une porosité ouverte.

La couche poreuse 101, disposée entre la couche de support 100 et la couche 102 de matériau semiconducteur polycristallin, permet d'empêcher que le matériau monocristallin de la couche de support 100 ne vienne, par recristallisation, rendre celui de la couche 102 monocristallin.

Il peut y avoir superposition entre la couche poreuse et la couche de piégeage. La couche poreuse 101 et la couche de piégeage peuvent être une seule et même couche.

Un substrat tel qu'illustré sur la figure 1 peut être amené à subir des étapes technologiques de réalisation de composants actifs et/ou passifs. Par exemple, des étapes de fabrication de transistors selon une technologie CMOS peuvent être réalisées à partir d'un tel substrat. Un dispositif microélectronique doté d'un transitor T réalisé sur un tel substrat est illustré sur la figure 2A.

Des composants RF, en particulier sous forme d'inductance(s) ou d'antenne(s) peuvent être également formés sur un tel substrat afin de réaliser un circuit RF, en particulier capable de fonctionnner à des fréquences au-delà de 700 MHz.

Sur la figure 2B, une piste conductrice 71 d'antenne ou d'inductance réalisée sur la couche superficielle 12 d'un tel substrat est ainsi représentée. En variante (non représentée), on peut prévoir un composant RF de type antenne ou inductance sur une région du substrat juxtaposée à la couche superficielle 12 et correspondant à une zone de la couche superficielle 12 remplacée par un autre matériau, par exemple de l'oxyde de silicium (SiO₂).

Un premier exemple de réalisation d'un substrat du type de celui décrit précédemment va à présent être donné.

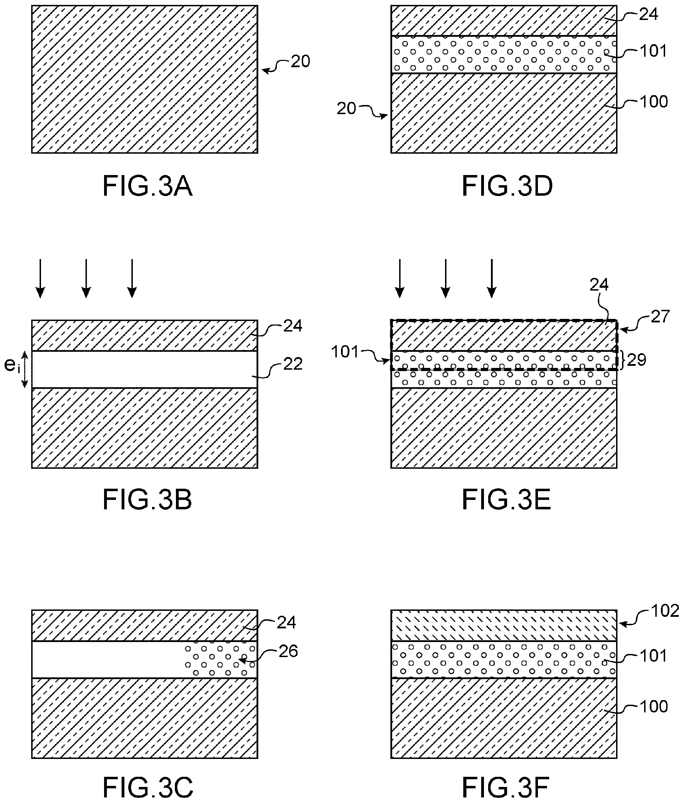

Un matériau de départ de ce procédé peut être un support 20 appelé substrat « socle » en matériau semi-conducteur monocristallin, en particulier un substrat massif (« bulk » selon la terminologie anglo-saxonne), par exemple en silicium, de préférence faiblement dopé, ce qui se traduit par une résistivité supérieure à 500 Ω.cm et avantageusement supérieure à 1 kΩ.cm (figure 3A).

On forme ensuite dans ce substrat 20 une couche poreuse, par exemple par porosification d'une couche de silicium, en particulier monocristallin.

Une méthode de réalisation de cette couche poreuse comprend une implantation d'ions légers, en particulier d'ions hydrogène ou d'un gaz rare tel que par exemple de l'Hélium, ou du Néon, ou de l'Argon.

La dose et l'énergie d'implantation peuvent être choisies en fonction de l'épaisseur que l'on souhaite conférer à la zone implantée 22 dans laquelle sera contenue la couche poreuse. On peut également choisir des conditions d'implantation de sorte à conserver une région 24 non-implantée en surface du support 20 (figure 3B). La zone implantée 22 qui, dans ce cas est qualifiée d'«enterrée » peut avoir une épaisseur eᵢ par exemple d'au moins 100 nm.

Dans cet exemple de réalisation, en surface du support 20, une région 24 non implantée d'épaisseur par exemple de 5 nm à 200 nm d'épaisseur peut être préservée.

La dose et l'énergie d'implantation peuvent être déterminées en utilisant un outil tel que SRIM (acronyme de « Stopping and Range of Ions in Matter ») ou TRIM (« Transport of ions in matter ») qui permet de modéliser l'interaction d'implantation ionique avec différents matériaux. Par exemple pour une implantation d'Hélium, on peut obtenir typiquement entre 2 et 10*10²¹ atomes implantés/cm³ en concentration moyenne sur l'épaisseur implantée.

Une calibration particulière de l'équipement d'implantation est réalisée en fonction du type de faisceau, de la densité de courant, du contrôle de température du substrat.

Pour permettre de conserver la région 24 non-implantée en surface du substrat socle 20 et éviter un phénomène intempestif d'exfoliation ou de décollement de cette région 24, on prévoit des conditions de dose et de température d'implantation adéquates inférieures à des seuils déterminés par l'Homme du Métier.

Pour permettre de compléter la formation de cavités également appelées pores 26 dans la zone 22 implantée, l'implantation est typiquement suivie d'au moins un premier recuit thermique (figure 3C).

La température et la durée du premier recuit sont choisies notamment en fonction de la taille ou du diamètre que l'on souhaite conférer aux pores. Des cavités ou pores de diamètre compris entre 2 nm et 250 nm, typiquement entre 5 nm et 150 nm, de préférence entre 5 nm et 20 nm peuvent être formé(s). Par exemple, un recuit à une température comprise par exemple entre 250°C et 1000°C et selon une durée comprise entre 5 min et 2 h 00 peut être mis en oeuvre.

La méthode de formation de pores peut également comprendre une implantation enterrée d'ions légers suivie d'un recuit laser. Une méthode de formation de pores telle que décrite par exemple dans la demande déposée par la demanderesse auprès de l'INPI et dont le numéro de dépôt est : FR1915019 (numéro de publication : FR3105574) peut être en particulier utilisée.

La longueur d'onde du laser peut être choisie de façon à ne pas être absorbée de manière significative par la couche d'oxyde 11 de silicium. Par exemple, on peut choisir une longueur d'onde dans le domaine ultra-violet, et plus particulièrement une longueur d'onde de 308 nm. Le laser peut être un laser pulsé, c'est-à-dire permettant de soumettre la structure à un rayonnement laser de façon intermittente par au moins une impulsion laser. L'impulsion ou chaque impulsion peut être d'une durée allant de la nanoseconde à la microseconde.

Une méthode de formation de pores telle que décrite par exemple dans la Thèse de doctorat « caracterização da implantaçâo de Ne em Si (100) », de Peripolli, 2007, et en particulier les chapitres 3 à 6, peut également être utilisée.

Pour permettre une évacuation ou de compléter l'évacuation d'espèces gazeuses implantées dans la couche dotée de pores, le premier recuit d'implantation peut être suivi d'au moins un deuxième recuit.

Dans un cas où l'espèce implantée est de l'Hélium, une méthode telle que décrite par exemple dans le document « Helium implantation in silicon: the effects of implantation température », de Oliviero et al., Materials Science and Engineering B102 (2003) peut être utilisée pour former la couche poreuse et permettre ensuite une désorption de l'Hélium implanté.

Une couche poreuse 101 avec une porosité au moins partiellement vide et/ou remplie de gaz, en particulier de gaz rare peut être ainsi obtenue (figure 3D).

Cette couche poreuse 101 est ainsi formée sur et en contact d'une couche de support 100 ainsi que sous et en contact d'une région 24 superficielle du substrat socle 20 non-poreuse.

On peut ensuite former une couche de matériau semi-conducteur polycristallin dans une région supérieure du substrat socle 20.

Pour cela, on peut transformer au moins une épaisseur ou portion supérieure 27 du substrat socle 20 en une région semi-conductrice riche en défauts cristallins et/ou en joints de grains.

Une méthode pour réaliser une telle région comprend la mise en oeuvre d'une implantation d'amorphisation, afin de rendre amorphe au moins une épaisseur de la région 24 superficielle du substrat socle non implantée et conservée non-poreuse.

La dose et l'énergie d'implantation peuvent être déterminées au préalable en utilisant des outils de simulation tels que cités précédemment.

Une implantation d'amorphisation peut être réalisée par exemple à l'aide d'ions lourds, formés à partir de Si ou de Ge, Ar, Xe, ou de F selon une dose par exemple de l'ordre de 10¹⁵at/cm².

Selon une possibilité de mise en oeuvre illustrée sur la figure 3E, on peut prévoir l'énergie d'implantation de sorte à réaliser une amorphisation de la région 24 superficielle non-poreuse et d'au moins une partie supérieure 29 de la couche poreuse 101.

On rend ainsi amorphe au moins une portion du squelette solide formé autour de la porosité. Ainsi, une amorphisation de silicium dans la partie supérieure 29 de la couche poreuse 101 peut être par exemple effectuée.

L'épaisseur de matériau amorphe, en particulier de silicium rendu amorphe peut être comprise par exemple entre 5 nm et 500 nm, de préférence entre 5 nm et 50 nm.

Il est également possible de compléter cette amorphisation par une étape de dépôt de matériau semi-conducteur amorphe, par exemple du silicium amorphe sur la portion supérieure 27 implantée. Dans ce cas, le dépôt est effectué de préférence de manière à former une couche amorphe de rugosité < 6Â rms (1×1 µm²).

On effectue ensuite au moins un recuit de recristallisation, de durée et de température prévues de manière à transformer le matériau semi-conducteur rendu amorphe en matériau riche en défauts cristallins et/ou en joints de grains. Le recuit peut être avantageusement un recuit rapide prévu en termes de durée et de température pour permettre de transformer le matériau semi-conducteur rendu amorphe en matériau polycristallin.

Par exemple, un recuit rapide, i.e. d'une durée inférieure à 10 secondes et avantageusement inférieure à 2 secondes à une température élevée de préférence supérieure à 800°C mais inférieure à 1400°C peut être effectué de façon à transformer du Si amorphe en Si polycristallin, la combinaison temps/température étant choisie de préférence de façon à obtenir une cristallisation rapide autour de germes multiples tout en évitant une uniformisation de l'orientation cristalline. Par exemple pour un recuit à 1050°C avec une rampe de montée de 100°C/seconde et une durée à 1050°C inférieure à 1 seconde. Selon une variante de réalisation, la formation d'un semiconducteur polycristallin peut également être mise en oeuvre à l'aide d'un recuit de recristallisation par laser. Un laser de type dit « nanosecondes » peut être avantageusement être utilisé comme cela est décrit par exemple dans la demande déposée par la demanderesse auprès de l'INPI et dont le numéro de dépôt est FR1914563 (numéro de publication : FR3104811).

On peut ainsi employer un laser à une longueur d'onde comprise entre 20 nm et 400 nm avec une durée d'impulsion typiquement inférieure à une microseconde et par exemple de l'ordre de une à plusieurs centaines de nanosecondes.

Dans tous les cas, une recristallisation éventuelle en silicium monocristallin ne peut être obtenue du fait de la présence de la couche poreuse.

On obtient ainsi (figure 3F) une couche supérieure 102 en un matériau polycristallin, par exemple du polysilicium et qui pourra former une couche de piégeage de charges (« trap-rich »), la couche de piégeage de charges 102 étant disposée sur la couche poreuse 101, qui elle aussi pourra former une couche de piégeage de charges (« trap-rich »). Cette couche poreuse 101 est dotée d'un squelette qui, en fonction de la profondeur d'implantation d'amorphisation est de préférence au moins en partie préservée monocristallin.

Sur cette couche 102 de piégeage de charges, on prévoit ensuite typiquement de reporter un empilement comprenant une couche isolante et une couche semi-conductrice, pour former un substrat de type semi-conducteur sur isolant.

De manière optionnelle, on peut réaliser une oxydation thermique d'une partie de la couche supérieure avant implantation d'amorphisation, ou même avant l'implantation pour conduire à la couche poreuse.

Dans l'exemple de réalisation qui vient d'être décrit, on effectue, après implantation pour former une couche poreuse, un recuit thermique optionnel afin de favoriser un dégazage des pores. En variante ou en combinaison, un tel dégazage peut être également mis en oeuvre lors du recuit de recristallisation du matériau amorphe. Un dégazage au moins partiel peut également être réalisé lorsque l'on effectue l'implantation de porosification, en particulier lorsque cette implantation est réalisée à haute température.

Selon une autre possibilité de mise en oeuvre, et en particulier en variante d'un procédé tel que décrit précédemment, le recuit permettant de favoriser un dégazage des pores, peut être réalisé après l'étape d'amorphisation, la température de recuit étant alors inférieure à une température de recristallisation en phase solide de la couche amorphe. Ainsi, si l'on se réfère par exemple au procédé décrit précédemment en lien avec les figures 3A-3F, le recuit thermique décrit précédemment en lien avec la figure 3C peut être en variante réalisé après l'amorphisation décrite précédemment en lien avec la figure 3E. Dans ce cas, on effectue ce recuit thermique à une température inférieure à la température de recuit de recristallisation, de préférence à une température inférieure à 500°C et qui est par exemple comprise entre 200°C et 450°C.

Un recuit tel qu'évoqué précédemment et permettant de favoriser un dégazage des pores est optionnel. Ainsi, selon une autre variante, de procédé on forme tout d'abord la couche poreuse à l'aide d'au moins une implantation, par exemple une implantation d'hélium, dans une région enterrée. On créé ensuite la zone amorphe au moins en partie au-dessus des cavités ou de la couche poreuse. Puis, un recuit de recristallisation de la zone amorphe, typiquement à l'aide d'un laser est mis en oeuvre. Un dégazage des pores peut être alors réalisé lors de ce recuit.

Après l'une ou l'autre des variantes de procédé telles que décrites précédemment un procédé de transfert de couches sur le socle formé de l'empilement de couches de support 100, de la couche poreuse 101, et de la couche de piégeage de charges 102 peut être ensuite réalisé.

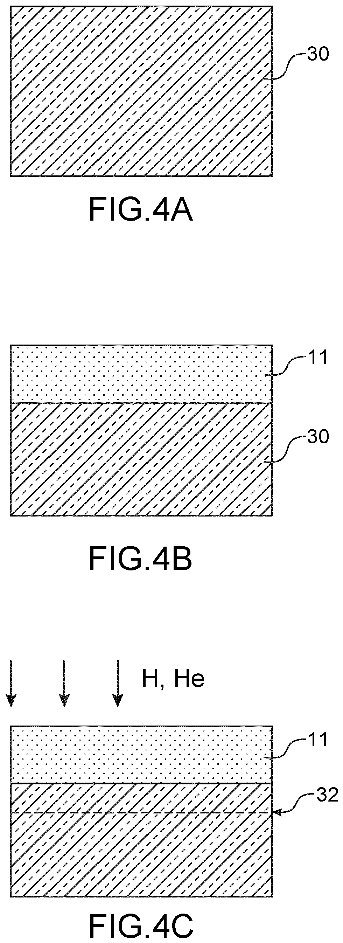

Un tel transfert est typiquement effectué au moyen d'un autre support appelé « substrat donneur » dont un exemple de procédé de fabrication est donné sur les figures 4A-4C.

Le substrat donneur 30 est au départ typiquement un substrat massif (figure 4A) en silicium de résisitivé par exemple de l'ordre de 10 Ω.cm, sur lequel on forme la couche isolante 11 d'oxyde de silicium (figure 4B). Une telle couche 11 est obtenue typiquement par oxydation thermique. La couche isolante 11 réalisée a une épaisseur qui peut être comprise par exemple entre 10 nm et 1000 nm.

On forme ensuite une zone de fragilisation 32 dans l'épaisseur du substrat donneur 30 (figure 4C), par exemple par implantation d'ions légers H+ et/ou He+ à une dose de préférence supérieure à 10¹⁶ at/cm² et, selon une énergie de préférence supérieure à 10 keV. Par exemple, une implantation de H⁺ selon une dose comprise entre 5*10¹⁶ at/cm² et 7 *10¹⁶ at/cm² et une énergie par exemple entre 20 keV et 30 keV peut être mise en oeuvre.

Un procédé de type smarcut^{™} peut être en particulier employé.

Le transfert sur le socle peut être ensuite réalisé au moyen d'un collage par adhésion moléculaire.

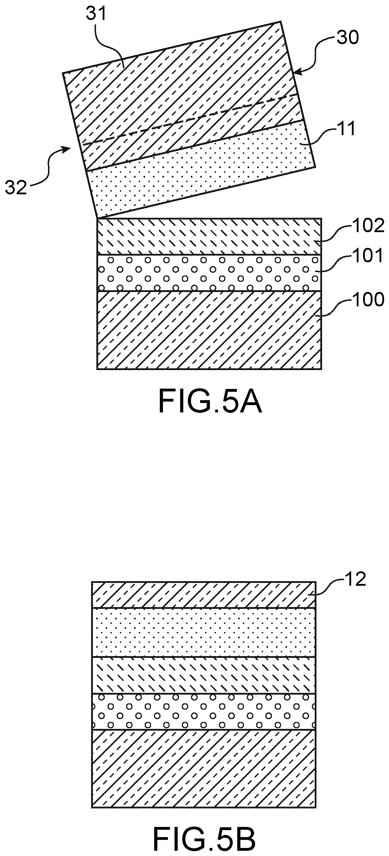

Une étape de report du substrat donneur 30 est illustrée sur la figure 5A. On colle ainsi la couche isolante 11 avec la couche de matériau semi-conducteur polycristallin 102.

De manière optionnelle, le socle peut être revêu d'une couche isolante typique en oxyde de silicium.

On réalise ensuite une fracturation du substrat donneur 30 au niveau de sa zone de fragilisation 32, de manière à ne conserver qu'une fine couche semi-conductrice du substrat 30 donneur.

Après séparation d'une partie du substrat donneur 30, on réalise un amincissement de la fine couche semi-conductrice de ce substrat 30 par oxydation d'une zone de matériau semi-conducteur et gravure de la zone oxydée suivie d'un recuit de lissage de la surface.

Cette fine couche semi-conductrice forme alors la couche semi-conductrice superficielle 12 du substrat semi-conducteur sur isolant (figure 5B).

D'autres techniques de transfert ou report utilisant un collage direct et un amincissement mécanique, chimique et/ou mécano-chimique peuvent être également utilisées. Ces procédés consistent à assembler le substrat donneur par adhésion moléculaire avec le substrat support, puis à amincir le substrat donneur jusqu'à l'épaisseur souhaitée de la fine couche semi-conductrice destinée à former une couche active, par exemple par rectification (« grinding » selon la terminologie anglo-saxonne) et par polissage mécano-chimique (CMP pour « chemical mechanical polishing »).

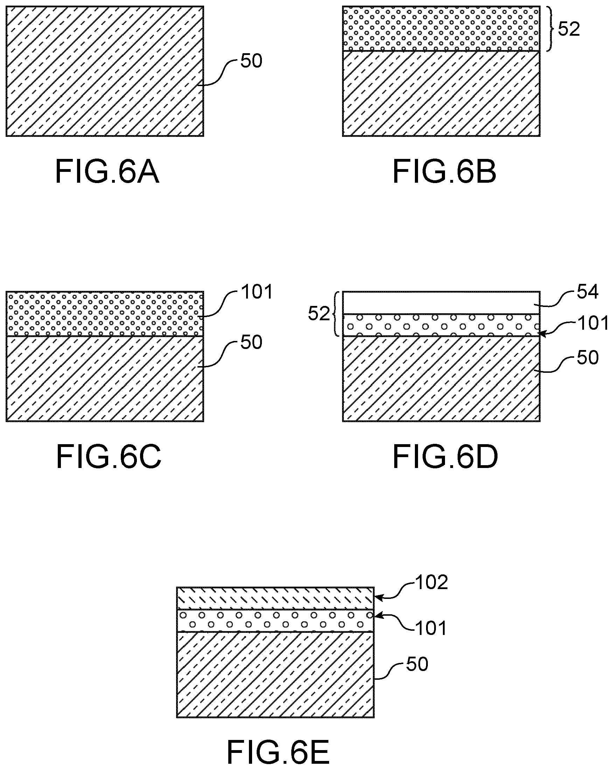

Une autre manière de réaliser la superposition de couches formant le socle du substrat prévoit la réalisation d'une couche poreuse en surface d'un substrat 50 semi-conducteur (figure 6A) en matériau semi-conducteur, en particulier un substrat massif (« bulk » selon la terminologie anglo-saxonne), par exemple en silicium.

La méthode de formation de la couche poreuse en surface d'un substrat 50 peut comprendre une implantation d'ions légers suivie d'un recuit laser conduisant à la formation de pores en surface. Une telle porosification de surface et par implantation est décrite par exemple dans la demande déposée par la demanderesse auprès de l'INPI et dont le numéro de dépôt est FR1915021. Cette demande FR1915021 est ici incorporée par référence.

Une ou plusieurs étapes de recuits peuvent être ensuite effectuées, notamment afin de stabiliser le matériau rendu poreux et d'évacuer, en particulier de l'hydrogène, des pores ou cavités. Pour cela, on peut effectuer un recuit sous atmosphère oxydante à une température par exemple de l'ordre de 300°C puis un deuxième recuit sous atmosphère neutre à une température de l'ordre de 420°C. On renforce alors le squelette de la structure poreuse avec de l'oxyde et on évacue ainsi de l'hydrogène suceptible d'être présent sur les parois des pores.

On obtient ainsi une couche poreuse 101 formée d'une distribution de pores typiquement vides (figure 6C). Dans la mesure où l'on effectue la porosification par implantation, la porosité obtenue est une porosité fermée.

La couche poreuse 101 ici obtenue est dotée d'un squelette qui, en peut être avantageusement préservé en totalité monocristallin, c'est-à-dire sur toute l'épaisseur de la couche 101.

Ensuite, on peut former une région amorphe 54 en surface du substrat socle 50, autrement dit au niveau de sa face supérieure rendue poreuse (figure 6D).

Une méthode de réalisation de cette région 54 comprend un dépôt d'une couche de matériau semi-conducteur amorphe, en particulier de Si amorphe, directement sur la couche poreuse 101.

On vise de préférence une couche amorphe de faible rugosité et en particulier inférieure à 6 Angstroms rms dans une surface de 1*1 µm².

On effectue ensuite au moins un recuit de recristallisation de manière à transformer au moins une épaisseur de la couche de matériau semi-conducteur amorphe en une couche 102 de piégeage de charges, typiquement en polysilicium (figure 6E).

Le recuit est de préférence un recuit rapide effectué à une température inférieure à 1100°C, par exemple à 1050°C avec rampe de montée de 100°C/s et dont la durée à la température maximale de 1050°C est prévue inférieure à 1 seconde. Le recuit peut également être un recuit de recristallisation par laser de type nanosecondes, comme cela est décrit plus haut.

À partir du socle ainsi réalisé, on peut ensuite compléter la formation d'un substrat de type semi-conducteur sur isolant, en effectuant par exemple un procédé tel que décrit précédemment en lien avec les figures 4A-4C et 5A-5B, durant lequel on effectue le report d'une couche isolante et d'une couche semi-conductrice superficielle sur le socle.

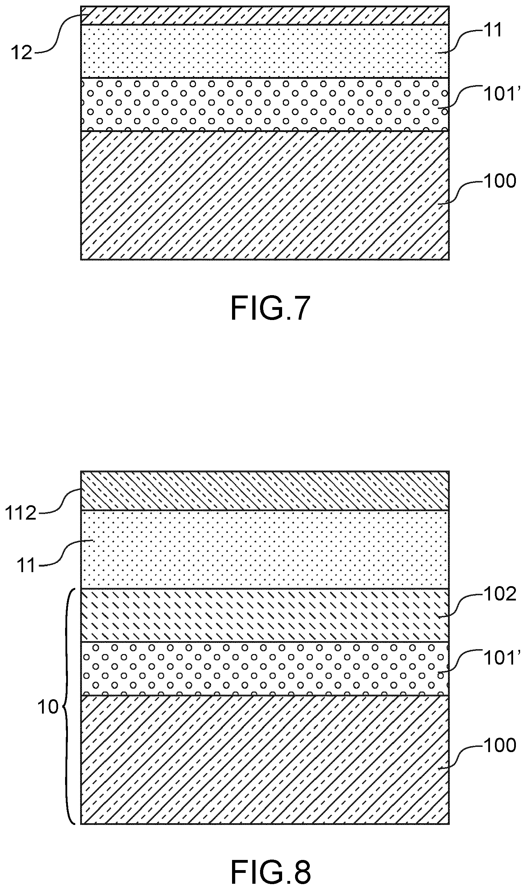

Une variante de réalisation de substrat de type semi-conducteur sur isolant est donnée sur la figure 7.

Pour cette variante, une couche 101' de piégeage de charges poreuse, dont le squelette est en partie en polysilicium poreux et en partie en silicium monocristallin poreux comportant une porosité avec des pores vides ou remplis de gaz est prévue. La couche 101' poreuse comporte une face supérieure en contact avec la couche isolante 11 du substrat et une face inférieure en contact avec une couche de support 100 semi-conductrice de résisistivité élevée.

Un procédé tel que décrit précédemment peut également s'appliquer à la mise en oeuvre d'un substrat de type POI (« Piezoelectric On Insulator », ou « piézoélectrique sur isolant ») amélioré.

Un tel substrat, représenté sur la figure 8, est doté d'une couche superficielle 112 en matériau piézoélectrique monocristallin par exemple tel que du Tantalate de lithium ou du Niobate de lithium et peut être utilisé par exemple pour la fabrication de composant RF tel qu'un filtre à ondes acoustique, en particulier à ondes acoustiques de surface (SAW pour « Surface Acoustique Wave »). Outre les avantages précités sur les pertes ohmiques, l'empilement formé de la couche de piégeages 102 et de la couche poreuse 101 permet de réduire le bruit lié à la propagation d'ondes parasites.

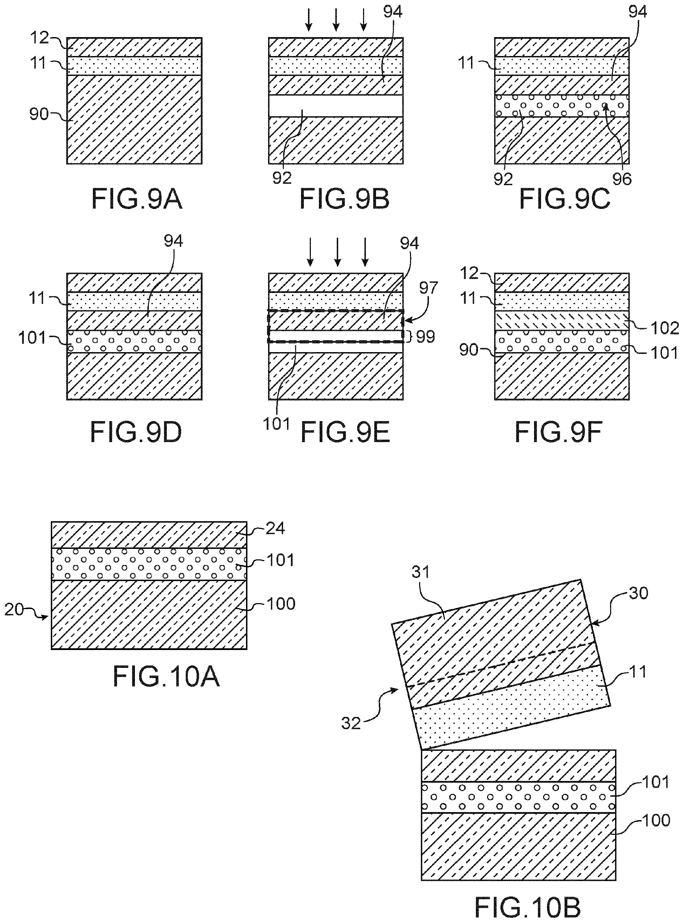

Selon une variante de réalisation, on utilise cette fois comme matériau de départ un substrat de type semi-conducteur sur isolant tel qu'illustré sur la figure 9A.

Le substrat est doté d'une couche semi-conductrice superficielle 12, par exemple en silicium, et repose sur une couche isolante 11, typiquement en oxyde de silicium 11. La couche isolante 11 est en contact avec la couche superficielle 12 et isole cette dernière d'une couche 90 de support, qui est semi-conductrice et typiquement en silicium.

Selon une variante de réalisation, on utilise comme matériau de départ un substrat avec une couche 90 de support, qui peut être semi-conductrice et par exemple en silicium, la couche de support étant revêtue d'une couche isolante 11 par en oxyde de silicium 11.

On forme ensuite une couche poreuse dans la couche de support 90. Une méthode de réalisation de cette couche poreuse comprend une implantation d'ions légers (figure 9B), en particulier d'ions hydrogène ou d'un gaz rare tel que par exemple de l'Hélium, ou du Néon, ou de l'Argon. La dose et l'énergie d'implantation sont choisies en fonction de l'épaisseur que l'on souhaite conférer à la zone 92 implantée et de sorte à conserver une région 94 non-implantée dans la couche de support 90 entre cette zone 92 et la couche isolante 11. On effectue ainsi l'implantation dans une zone 92 dite « enterrée ». La dose et l'énergie d'implantation peuvent être déterminées à l'aide d'outils tels que donnés précédemment. De préférence l'implantation se fait selon un angle d'inclinaison de l'ordre de zéro degré par rapport à une normale à un plan principal du substrat. Cela favorise un non-endommagement de la région en surface. Une telle implantation conduit à la formation d'une couche enrichie en éléments implantés 96.

Dans un cas où l'espèce implantée est de l'Hélium, une méthode telle que décrite par exemple dans le document « Helium implantation in silicon: the effects of implantation température », de Oliviero et al., Materials Science and Engineering B102 (2003) peut être utilisée pour former la couche poreuse et permettre ensuite une désorption de l'Hélium implanté. Des doses plus élevées que celle décrites dans ce document et comprises par exemple entre 0.5^{e}16 et 7^{e}16 He/cm²peuvent être prévues.

On réalise ensuite au moins un recuit thermique (figure 9C) à une température et une durée choisies en fonction de la taille ou du diamètre que l'on souhaite conférer aux pores ou un recuit laser. Par exemple, un recuit à une température comprise entre 250°C et 1000°C et selon une durée comprise entre 5 min et 2 h 00 peut être mis en oeuvre. On réalise ainsi une couche poreuse 101 avec une porosité au moins partiellement vide et/ou remplie de gaz, en particulier de gaz rare (figure 9D).

Puis, on forme une couche de piégeage de charges dans une région supérieure de la couche de support 90.

Une méthode comprend la mise en oeuvre d'une implantation d'amorphisation, afin de rendre amorphe la région 94 non implantée qui se trouve entre la couche isolante 11 et la couche poreuse 101. Cette implantation est, là encore, une implantation d'une région enterrée qui ne se trouve pas en surface du support implanté.

L'implantation d'amorphisation peut être réalisée par exemple à l'aide de Si ou de Ge ou F. Un exemple de procédé d'obtention d'une région amorphe enterrée par implantation ionique est donné dans le document « Dopant-enhanced solid phase epitaxy in buried amorphous silicon layers » de Johnson et al. 2010, Physical review. B, Condensed matter 76(4) ou dans le document « Formation of amorphous layers by ion implantation » de S. Prussin et al., Journal of Applied Physics 57, 180 (1985) ou dans le document « Amorphization/recrystallization of buried amorphous silicon layer induced by oxygen ion implantation » de J. P. de Souza, Journal of Applied Physics 95, 877 (2004). L'implantation est réalisée typiquement à une température du substrat plus faible qu'une température permettant un recuit dynamique de défauts créés pendant l'implantation. Par exemple, pour rendre amorphe le silicium on réalise l'implantation à une température inférieure à 250°C et de préférence à une température T inférieure à 100°C. Une implantation à très faible température du substrat peut être mise en oeuvre.

Par exemple, l'implantation de la zone 22 enterrée peut être effectuée à l'aide de Lithium en mettant le substrat à une température qui peut correspondre à celle de l'azote liquide, en mettant en oeuvre un procédé du type de celui décrit par exemple dans le document « Lithium implantation at low température in silicon for sharp buried amorphous layer formation and defect engineering », Journal of Applied Physics 113, 083515 (2013), E. Oliviero et al.

Pour rendre amorphe le silicium on peut utiliser par exemple une espèce choisie parmi au moins une des suivantes : Si, C, O, Ne. De préférence l'implantation se fait avec un angle d'inclinaison d'angle de l'ordre de zéro degré par rapport à une normale à un plan principal du substrat, ce qui favorise une préservation de la couche semi-conductrice superficielle du substrat.

Selon une possibilité de mise en oeuvre illustrée sur la figure 9E, on peut prévoir l'énergie d'implantation de sorte à réaliser une amorphisation d'une zone 97 comprenant la région 94 non-poreuse de la couche de support située sous la couche isolante 11 et d'au moins une partie supérieure 99 de la couche poreuse 101 située sous cette région 94. On rend ainsi amorphe au moins une portion du squelette solide formé autour des pores et en particulier de sa partie supérieure.

On effectue ensuite au moins un recuit de recristallisation, de durée et de température prévus de manière à transformer le matériau semi-conducteur rendu amorphe en matériau riche en défauts cristallins et/ou en joints de grains. Le recuit peut être avantageusement un recuit rapide prévu en termes de durée et de température pour permettre de transformer le matériau semi-conducteur rendu amorphe en matériau polycristallin. Par exemple, un recuit rapide, i.e. d'une durée inférieure à 10 secondes et avantageusement inférieure à 2 secondes à une température élevée de préférence supérieure à 800°C mais inférieure à 1400°C peut être effectué de façon à transformer du Si amorphe en Si polycristallin.

Un recuit laser de type nanosecondes peut être effectué. La source laser peut émettre avantageusement dans le domaine UV, le laser ayant par exemple une longueur d'onde de l'ordre de 308 nm et en émettant une ou plusieurs impulsions chacune de durée comprise entre 1 ns et 1 µs, par exemple de l'ordre de 200 ns.

Ce recuit peut également être adapté à former des germes cristallins dans l'amorphe, suivi par un recuit par exemple de type RTA (pour « Rapid Thermal Anneal ») ou conventionnel afin de développer une structure de poly-Si.

On obtient ainsi (figure 9F) une couche 102 de matériau polycristallin, par exemple du polysilicium et qui pourra former une couche de piégeage de charges (« trap-rich »).

Une réparation de la structure cristalline de la couche superficielle 12 peut être ensuite mise en oeuvre. On réalise pour cela un recuit thermique à haute température typiquement supérieur à 900°C et de préférence inférieur à 1150°C pour une durée comprise par exemple entre 5 min et 4 h.

Selon une autre possibilité de mise en oeuvre illustrée sur les figures 10A-10B, on peut réaliser tout d'abord (figure 10A) la couche poreuse 101 dans un substrat socle 20 massif (bulk). Puis, on effectue (figure 10B) un transfert du type de celui décrit précédemment en liaison avec les figures 5A-5B, d'un substrat donneur 30 revêtu de la couche isolante 11 sur le socle. Ensuite, on forme la couche de semi-conducteur polycristallin 102.

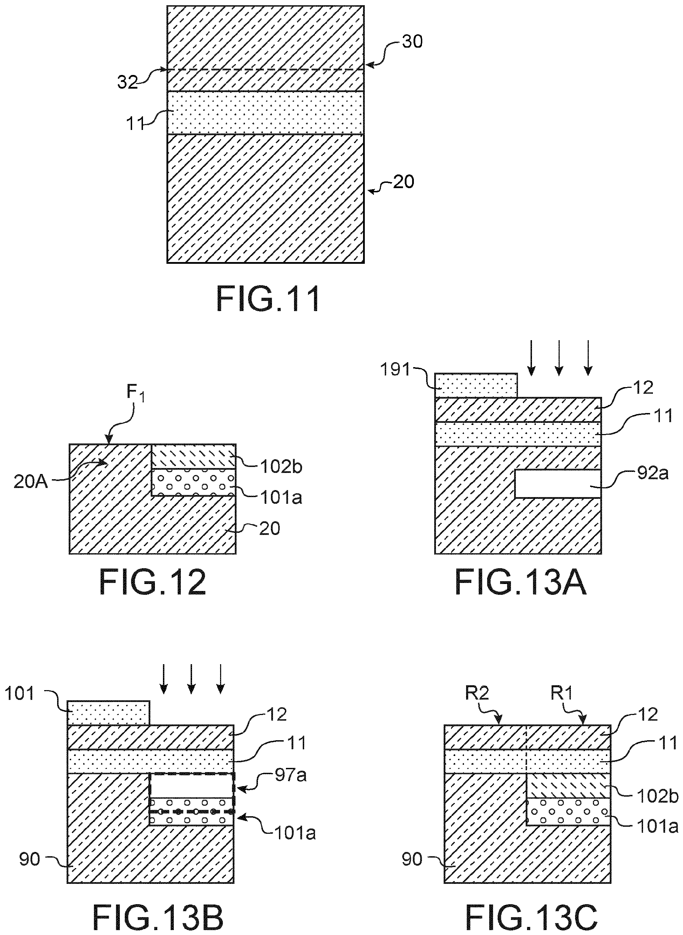

Selon une autre possibilité de mise en oeuvre, la couche poreuse 101 et la couche de matériau polycristallin 102 peuvent être réalisées après l'obtention d'une structure telle qu'illustrée sur la figure 11 obtenue à l'aide d'un transfert du type de celui décrit en liaison avec la figure 5A, d'un substrat donneur 30 revêtu d'une couche isolante 11 sur un socle sous forme de substrat 20 massif (bulk).

On réalise dans ce cas les implantations et recuit pour former les couches poreuse 101, de semi-conducteur polycristallin 102, avant la ou les étapes de finition conduisant à l'obtention de la couche semi-conductrice superficielle 12. Ainsi, on peut réaliser ces étapes avant une oxydation d'amincissement finale ou avant un recuit de lissage à fort budget thermique.

On peut également prévoir, de réaliser les couches poreuse 101 et de semi-conducteur polycristallin 102 après le transfert décrit précédemment et en particulier après la fracturation du substrat donneur 30, mais avant une étape d'amincissement par exemple par oxydation conduisant à l'obtention de la couche semi-conductrice superficielle 12.

Selon une variante de réalisation de l'un où l'autre des procédés décrits précédemment, on peut former une couche ou région de piégeage de charges localisée, c'est-à-dire qui s'étend en regard d'une région donnée seulement de la couche semi-conductrice superficielle 12 du substrat semi-conducteur, cette région donnée de la couche superficielle 12 étant typiquement celle sur laquelle on réalise un ou plusieurs composants RF.

Ainsi, dans l'exemple de réalisation illustré sur la figure 12, où l'on part d'un substrat socle 20 de type substrat massif, on réalise une couche poreuse 101a et une couche 102a en polysilicium sur cette dernière pour former une couche de piégeage de charge localisées et qui ne s'étendent pas sur toute la largeur du support 20.

L'empilement de couches poreuse 101a et de piégeage 102a sont ici juxtaposées à une zone 20A du substrat socle 20 conservée intacte, autrement dit ni porosifiée ni rendue polycristalline. Pour obtenir un tel agencement, on effectue typiquement un masquage d'une région du substrat socle 20 en regard de la zone 20A lors d'étapes d'implantation telles que décrites précédemment, et en particulier lors de la ou les étape(s) d'implantation au moyens d'ions légers pour réaliser la couche poreuse 101a puis lors de la ou les étape(s) d'amorphisation pour réaliser une zone amorphe sur cette couche poreuse et que l'on soumet ensuite à un traitement thermique afin de réaliser la couche 102a de matériau polycristallin.

La structure ainsi obtenue et illustrée sur la figure 12 peut ensuite faire l'objet d'un report comme dans l'exemple de réalisation décrit précédemment en liaison avec les figures 5A-5B afin de réaliser un substrat de type semi-conducteur sur isolant.

Ainsi, on reporte sur la couche isolante 11 d'un substrat donneur 30 une face F1 du substrat socle 20 du côté de laquelle la couche de matériau semi-conducteur polycristallin 102a est localisée et qui peut être dévoilée au niveau de cette face F1. On réalise ensuite une fracturation du substrat donneur 30, de manière à ne conserver qu'une fine couche semi-conductrice 12 de ce dernier. Cette couche semi-conductrice 12 forme alors la couche superficielle d'un substrat semi-conducteur sur isolant muni d'une couche de piégeage de charges.

Dans un autre exemple de réalisation illustré sur les figures 13A-13C, la couche poreuse localisée et la couche de matériau semi-conducteur polycristallin localisée sont cette fois réalisées dans un substrat de type semi-conducteur sur isolant et par exemple tel que le substrat 90 décrit précédemment en lien avec la figure 9A.

Pour obtenir une couche de piégeage localisée et qui ne s'étend en regard que d'une partie de la couche on forme typiquement un masque 191 sur une région du substrat afin de protéger cette région donnée lors de l'implantation d'une zone 92a située sous la couche isolante 11 et à distance de cette dernière (figure 13A) pour réaliser la couche poreuse. Le masque 191 est choisi en fonction de la technologie utilisée et peut être fait selon l'étape d'intégration pour protéger également d'autres zones du substrat, des dispositifs ou empilements déjà présents. Ce masque 191 peut-être une résine de lithographie, ou un masque dur par exemple. Le masque dur peut être formé de SiN, ou SiO₂, ou de carbone amorphe, ou d'un empilement d'un ou plusieurs de ces matériaux.

Puis, lors de l'étape d'implantation d'amorphisante, on conserve un masque, de préférence le même masque 191 (figure 13B) sur la même région donnée du substrat afin d'implanter une zone 97a située sous la couche isolante 11 du substrat et qui s'étend jusque dans la partie supérieure de la couche poreuse 101a.

Après une étape optionnelle de retrait du masque 191 et une étape de recuit pour transformer au moins une partie de la zone implantée 97a en matériau polycristallin, on obtient (figure 13C), sous la couche isolante 11 d'un substrat de type semi-conducteur sur isolant, une couche de matériau polycristallin localisée 102a agencée sur une couche poreuse localisée 101a. La couche de matériau semi-conduteur polycristallin 102a et la couche poreuse 101a sont ainsi disposées en regard d'une région donnée R1 de ladite couche superficielle 12, par exemple dédiée à un composant ou un circuit RF. Une autre région R2 de cette couche superficielle 12 juxtaposée à la région donnée R1 et qui peut être par exemple dédié à d'autres types de composants, n'est quant à elle, pas située en regard de ladite couche de matériau semi-conduteur polycristallin 102a ou de ladite couche poreuse 101a.

Selon une autre variante de procédé, on peut également réaliser l'amorphisation par implantation et la recristallisation de la zone rendue amorphe en polycristallin avant même d'effectuer la porosification et en particulier avant de réaliser la ou les implantations permettant de former la pororosité, par exemple par implantation d'Hélium. De manière optionnelle, cette implantation de porosification peut être réalisée à haute température .

Ainsi, si l'on se réfère à l'exemple de procédé décrit précédemment en lien avec les figures 9A-9F, on peut réaliser la zone amorphe entérée et une recristallisation de cette zone avant même de réaliser la couche poreuse enterrée dont la réalisation a été décrite en liaison avec les figures 9B-9C.

La porosification est avantageusement réalisée immédiatement la recristallisation tout en conservant un budget thermique limité entre ces deux étapes.

Selon une autre variante de procédé, on peut également réaliser l'amorphisation par implantation avant même d'effectuer la ou les implantations permettant de former la pororosité, par exemple par implantation d'Hélium. De manière optionnelle, cette implantation peut être réalisée à haute température. Puis, après porosification, on réalise un recuit de recristallisation, par exemple à l'aide d'un laser afin de recristalliser la zone rendue amorphe. Un tel recuit peut être prévu à une température permettant de dégazer les pores.

## Revendications

1. Structure dotée d'un substrat comprenant une couche superficielle (12, 112) sur laquelle ou au dessus de laquelle au moins un composant, en particulier un composant de circuit RF, est formé ou est destiné à être formé, ladite couche superficielle (12, 112) étant disposée sur, et en contact avec, une couche isolante (11), ladite couche isolante étant disposée sur, et en contact avec, un socle (10), ledit socle comprenant :
- une couche (100) de support en matériau semi-conducteur donné,
- une couche de piégeage de charges (102, 101') comprenant une couche (102, 102a) en matériau semi-conducteur polycristallin située entre ladite couche isolante (11) et ladite couche (100) de support, ledit socle comprenant en outre, entre ladite couche (100) de support et ladite couche isolante (11) :
- une couche poreuse (101, 101') dotée d'une face inférieure en contact avec ladite couche de support (100), ladite couche poreuse (101, 101a, 101') étant formée d'un squelette solide et d'une distribution de pores fermés vides et/ou remplis d'un gaz.

2. Structure selon la revendication 1, ladite couche de matériau semi-conducteur polycristallin (102, 102a) comprenant une face supérieure en contact avec ladite couche isolante (11), et une face inférieure opposée à ladite face supérieure, ladite face inférieure étant en contact avec ladite couche poreuse (101, 101a).

3. Structure selon la revendication 2, une portion supérieure dudit squelette solide de la couche poreuse (101, 101a) étant en contact avec ladite face inférieure de ladite couche de matériau semi-conducteur polycristallin (102, 102a) et étant également en matériau semi-conducteur polycristallin.

4. Structure selon la revendication 2, dans laquelle le squelette solide de la couche poreuse (101, 101a) est en matériau semi-conducteur monocristallin, en particulier intégralement en matériau semi-conducteur monocristallin, la couche poreuse (101, 101a) et la couche en matériau semi-conducteur polycristallin étant superposées.

5. Structure selon l'une des revendications 1 à 4, la couche de piégeage de charges et la couche poreuse étant des couches distinctes, ledit squelette solide étant au moins en partie monocristallin.

6. Structure selon l'une des revendications 1 à 5, une couche de matériau semi-conducteur amorphe étant agencée entre la couche de piégeage de charges (102, 101') et la couche poreuse (101, 101').

7. Structure selon l'une des revendications 1 à 6, dans lequel ladite couche de matériau semi-conducteur polycristallin (102a) et ladite couche poreuse (101a) sont localisées en regard d'une région donnée (R1) de ladite couche superficielle (12), une autre région (R2) de ladite couche superficielle (12) juxtaposée à ladite région donnée (R1) n'étant pas située en regard de ladite couche de matériau semi-conducteur polycristallin (102a) ou de ladite couche poreuse (101a).

8. Dispositif microélectronique comprenant une structure selon l'une des revendications 1 à 7, dans lequel ladite couche superficielle est une couche semi-conductrice (12), le dispositif comprenant :
- au moins un transistor, ledit transistor ayant une région de canal agencée dans ladite couche semi-conductrice superficielle (12), et/ou,
- un composant RF, en particulier de type inductance ou antenne.

9. Procédé de fabrication d'une structure selon l'une des revendications 1 à 7, dans lequel la couche poreuse (101) est réalisée par porosification d'une couche en matériau semi-conducteur donné dudit socle par une implantation, en particulier d'hydrogène ou de gaz rare, l'implantation étant suivie d'un recuit thermique et/ou d'un traitement laser.

10. Procédé selon la revendication 9, dans lequel ladite implantation est effectuée de sorte à former en surface dudit socle (20) une région de surface (24) poreuse.

11. Procédé selon l'une des revendications 9 ou 10, dans lequel la réalisation de la couche (102, 102a) en matériau semi-conducteur polycristallin comprend un dépôt d'une couche de matériau semi-conducteur amorphe sur la couche poreuse.

12. Procédé selon l'une des revendications 9 ou 10, dans lequel la réalisation de la couche (102, 102a) en matériau semi-conducteur polycristallin comprend une implantation d'amorphisation d'une région dudit socle (20) de sorte à former une région amorphe.

13. Procédé selon la revendication 12 lorsque rattachée à la revendication 10, dans lequel ladite couche poreuse est formée par implantation d'ions de sorte à conserver sur la couche poreuse une région de surface (24) non poreuse, ladite implantation d'amorphisation étant réalisée de sorte à former la région amorphe dans au moins ladite région de surface (24) ou au moins ladite région de surface (24) et une partie supérieure (29) de ladite couche poreuse (101).

14. Procédé selon l'une des revendications 11 à 13, dans lequel le procédé comprend en outre une étape de recristallisation, par un recuit laser et/ou par recuit thermique de température et de durée prévues de sorte à transformer ladite couche semi-conducteur amorphe ou ladite région amorphe en ladite couche (102) de matériau polycristallin.

15. Procédé selon l'une des revendications 8 à 12, dans lequel ladite couche poreuse (101) et ladite couche de matériau polycristallin (102) sont réalisées dans un substrat massif ou d'un substrat massif recouvert d'une couche isolante formant ledit socle (20), le procédé comprenant une étape de report d'un substrat donneur (30) sur ledit substrat massif, ledit substrat donneur (30) comprenant une couche isolante (11) et une couche en matériau piézoélectrique ou semi-conductrice dans laquelle ladite couche superficielle est apte à être formée.

## Patentansprüche

1. Struktur, die mit einem Substrat dotiert ist, das eine Oberflächenschicht (12, 112) umfasst, auf der oder über der mindestens eine Komponente, insbesondere eine Komponente einer RF-Schaltung gebildet ist, oder dazu bestimmt ist, gebildet zu werden, wobei die Oberflächenschicht (12, 112) auf, und in Kontakt mit einer Isolierschicht (11) angeordnet ist, wobei die Isolierschicht auf, und in Kontakt mit einem Sockel (10) angeordnet ist, wobei der Sockel umfasst:
- eine Trägerschicht (100) aus einem gegebenen Halbleitermaterial,
- eine Ladungseinfangschicht (102, 101'), umfassend eine Schicht (102, 102a) aus polykristallinem Halbleitermaterial, die sich zwischen der Isolierschicht (11) und der Trägerschicht (100) befindet, wobei der Sockel weiter zwischen der Trägerschicht (100) und der Isolierschicht (11) umfasst:
- eine poröse Schicht (101, 101'), die mit einer Unterseite in Kontakt mit der Trägerschicht (100) dotiert ist, wobei die poröse Schicht (101, 101a, 101') aus einem festen Skelett und einer Verteilung von leeren und/oder mit einem Gas gefüllten geschlossenen Poren gebildet ist.

2. Struktur nach Anspruch 1, wobei die Schicht aus polykristallinem Halbleitermaterial (102, 102a) eine Oberseite in Kontakt mit der Isolierschicht (11), und eine der Oberseite gegenüberliegende Unterseite umfasst, wobei die Unterseite in Kontakt mit der porösen Schicht (101, 101a) ist.

3. Struktur nach Anspruch 2, wobei ein oberer Abschnitt des festen Skeletts der porösen Schicht (101, 101a) in Kontakt mit der Unterseite der Schicht aus polykristallinem Halbleitermaterial (102, 102a) und auch aus einem polykristallinen Halbleitermaterial ist.

4. Struktur nach Anspruch 2, wobei das feste Skelett der porösen Schicht (101, 101a) aus einem monokristallinen Halbleitermaterial, insbesondere vollständig aus monokristallinem Halbleitermaterial ist, wobei die poröse Schicht (101, 101a) und die Schicht aus polykristallinem Halbleitermaterial überlagert sind.

5. Struktur nach einem der Ansprüche 1 bis 4, wobei die Ladungseinfangschicht und die poröse Schicht unterschiedliche Schichten sind, wobei das feste Skelett mindestens teilweise monokristallin ist.

6. Struktur nach einem der Ansprüche 1 bis 5, wobei eine Schicht aus amorphem Halbleitermaterial zwischen der Ladungseinfangschicht (102, 101') und der porösen Schicht (101, 101') angeordnet ist.

7. Struktur nach einem der Ansprüche 1 bis 6, wobei die Schicht aus polykristallinem Halbleitermaterial (102a) und die poröse Schicht (101a) gegenüber einer gegebenen Region (R1) der Oberflächenschicht (12) lokalisiert sind, wobei sich eine andere Region (R2) der Oberflächenschicht (12) nebeneinanderliegend zur gegebenen Region (R1) nicht gegenüber der Schicht aus polykristallinem Halbleitermaterial (102a) oder der porösen Schicht (101a) befindet.

8. Mikroelektronische Vorrichtung, umfassend eine Struktur nach einem der Ansprüche 1 bis 7, wobei die Oberflächenschicht eine Halbleiterschicht (12) ist, wobei die Vorrichtung umfasst:
- mindestens einen Transistor, wobei der Transistor eine Kanalregion aufweist, die in der Oberflächenhalbleiterschicht (12) angeordnet ist, und/oder,
- eine RF-Komponente, insbesondere in der Art einer Induktivität oder Antenne.

9. Verfahren zum Herstellen einer Struktur nach einem der Ansprüche 1 bis 7, wobei die poröse Schicht (101) durch Porenbildung einer Schicht aus einem gegebenen Halbleitermaterial des Sockels, durch eine Implantierung, insbesondere von Wasserstoff oder Edelgas gefertigt wird, wobei auf die Implantierung ein thermisches Tempern und/oder eine Laserbehandlung folgt.

10. Verfahren nach Anspruch 9, wobei die Implantierung durchgeführt wird, um an der Oberfläche des Sockels (20) eine poröse Oberflächenregion (24) zu bilden.

11. Verfahren nach einem der Ansprüche 9 oder 10, wobei die Fertigung der Schicht (102, 102a) aus polykristallinem Halbleitermaterial ein Abscheiden einer amorphen Schicht aus Halbleitermaterial auf der porösen Schicht umfasst.

12. Verfahren nach einem der Ansprüche 9 oder 10, wobei die Fertigung der Schicht (102, 102a) aus polykristallinem Halbleitermaterial eine Implantierung einer Amorphisierung einer Region des Sockels (20) umfasst, um eine amorphe Region zu bilden.

13. Verfahren nach Anspruch 12, wenn an den Anspruch 10 gebunden, wobei die poröse Schicht durch Implantieren von Ionen gebildet wird, um auf der porösen Schicht eine nicht poröse Oberflächenregion (24) beizubehalten, wobei die Implantierung einer Amorphisierung ausgeführt wird, um die amorphe Region in mindestens der Oberflächenregion (24) oder mindestens der Oberflächenregion (24) und einem oberen Teil (29) der porösen Schicht (101) zu bilden.

14. Verfahren nach einem der Ansprüche 11 bis 13, wobei das Verfahren weiter einen Schritt zur Rekristallisation durch ein Laser-Tempern und/oder durch thermisches Tempern und für eine Dauer umfasst, die vorgesehen sind, um die amorphe Halbleiterschicht oder die amorphe Region in die Schicht (102) aus polykristallinem Material umzuwandeln.

15. Verfahren nach einem der Ansprüche 8 bis 12, wobei die poröse Schicht (101) und die Schicht aus polykristallinem Material (102) in einem massiven Substrat oder einem massiven Substrat gefertigt sind, das von einer Isolierschicht abgedeckt ist, die den Sockel (20) bildet, wobei das Verfahren einen Schritt des Übertragens eines Donorsubstrats (30) auf das massive Substrat umfasst, wobei das Donorsubstrat (30) eine Isolierschicht (11) und eine Schicht aus piezoelektrischem oder halbleitendem Material umfasst, in der die Oberflächenschicht imstande ist, gebildet zu werden.

## Claims

1. A structure provided with a substrate comprising a surface layer (12, 112) on which or above which at least one component, in particular an RF circuit component, is formed or is intended to be formed, said surface layer (12, 112) being disposed on, and in contact with, an insulating layer (11), said insulating layer being disposed on, and in contact with, a base (10), said base comprising:
- a support layer (100) made of a given semiconductor material,
- a charge trapping layer (102, 101') comprising a layer (102, 102a) made of polycrystalline semiconductor material located between said insulating layer (11) and said support layer (100), said base further comprising, between said support layer (100) and said insulating layer (11):
- a porous layer (101, 101') provided with a lower face in contact with said support layer (100), said porous layer (101, 101a, 101') being formed of a solid skeleton and a distribution of pores which are closed empty and/or filled with a gas.

2. The structure according to claim 1, said polycrystalline semiconductor material layer (102, 102a) comprising an upper face in contact with said insulating layer (11), and a lower face opposite said upper face, said lower face being in contact with said porous layer (101, 101a).

3. The structure according to claim 2, an upper portion of said solid skeleton of the porous layer (101, 101a) being in contact with said lower face of said polycrystalline semiconductor material layer (102,102a) and also being made of polycrystalline semiconductor material.

4. The structure according to claim 2, wherein the solid skeleton of the porous layer (101, 101a) is made of monocrystalline semiconductor material, in particular entirely made of monocrystalline semiconductor material, the porous layer (101, 101a) and the polycrystalline semiconductor material layer being superimposed.

5. The structure according to one of claims 1 to 4, the charge trapping layer and the porous layer being distinct layers, said solid skeleton being at least partly monocrystalline.

6. The structure according to one of claims 1 to 5, a layer of amorphous semiconductor material being arranged between the charge trapping layer (102, 101') and the porous layer (101, 101').

7. The structure according to one of claims 1 to 6, wherein said polycrystalline semiconductor material layer (102a) and said porous layer (101a) are located opposite a given region (R1) of said surface layer (12), another region (R2) of said surface layer (12) juxtaposed to said given region (R1) not being located opposite said polycrystalline semiconductor material layer (102a) or said porous layer (101a).

8. A microelectronic device comprising a structure according to one of claims 1 to 7, wherein said surface layer is a semiconductor layer (12), the device comprising:
- at least one transistor, said transistor having a channel region arranged in said surface semiconductor layer (12), and/or,
- an RF component, in particular of the inductor or antenna type.

9. A method for manufacturing a structure according to one of claims 1 to 7, wherein the porous layer (101) is produced by porosification of a layer made of given semiconductor material of said base by an implantation, in particular of hydrogen or rare gas, the implantation being followed by thermal annealing and/or laser treatment.

10. The method according to claim 9, wherein said implantation is carried out so as to form on the surface of said base (20) a porous surface region (24).

11. The method according to one of claims 9 or 10, wherein the production of the layer (102, 102a) of polycrystalline semiconductor material comprises a deposition of a layer of amorphous semiconductor material on the porous layer.

12. The method according to one of claims 9 or 10, wherein the production of the layer (102, 102a) made of polycrystalline semiconductor material comprises an implantation of amorphisation of a region of said base (20) so as to form an amorphous region.

13. The method according to claim 12 when attached to claim 10, wherein said porous layer is formed by implantation of ions so as to maintain on the porous layer a non-porous surface region (24), said amorphisation implantation being carried out so as to form the amorphous region in at least said surface region (24) or at least said surface region (24) and an upper part (29) of said porous layer (101).

14. The method according to one of claims 11 to 13, wherein the method further comprises a step of recrystallisation, by laser annealing and/or by thermal annealing of temperature and duration provided so as to transform said amorphous semiconductor layer or said amorphous region into said polycrystalline material layer (102).

15. The method according to one of claims 8 to 12, wherein said porous layer (101) and said polycrystalline material layer (102) are produced in a solid substrate or a solid substrate covered with an insulating layer forming said base (20), the method comprising a step of transferring a donor substrate (30) onto said solid substrate, said donor substrate (30) comprising an insulating layer (11) and a piezoelectric material or semiconductor layer, wherein said surface layer is able to be formed.
